Europäisches Patentamt

European Patent Office

Office européen des brevets

(19)

(11)  EP 0 619 385 B1

(12)  **FASCICULE DE BREVET EUROPEEN**

(45) Date de publication et mention
de la délivrance du brevet:
**20.03.1996  Bulletin 1996/12**

(51) Int Cl.6: **C23C 16/40**, C23C 16/52

(21) Numéro de dépôt: **94400725.1**

(22) Date de dépôt: **01.04.1994**

(54) **Procédé et dispositif de contrôle de la teneur en bore du borophosphosilicate**

Verfahren und Vorrichtung zur Überwachung des Borgehalts in Borophosphosilikat

Process and apparatus to control the content of boron in borophosphosilicates

(84) Etats contractants désignés:
**DE GB NL**

(30) Priorité: **06.04.1993 FR 9304069**

(43) Date de publication de la demande:
**12.10.1994  Bulletin 1994/41**

(73) Titulaire: **MATRA MHS**
**F-44087 Nantes Cédex 03 (FR)**

(72) Inventeur: **Charpentier, Alain Yves Pierre**
**F-44000 Nantes (FR)**

(74) Mandataire: **Fréchède, Michel et al**
**Cabinet Plasseraud**
**84, rue d'Amsterdam**
**F-75440 Paris Cédex 09 (FR)**

(56) Documents cités:
- **RCA REVIEW vol. 46, no. 2 , Juin 1985 , PRINCETON pages 117 - 152 W.KERN ET AL 'optimized chemical vapour deposition of borophosphosilicate glass films'**
- **J.ELECTROCHEM.SOC.:ELECTROCHEMICAL TECHNOLOGY vol. 117, no. 4 , Avril 1970 , LONDON pages 562 - 568 W.KERN ET AL 'chemical vapour deposition of silicate glasses for use with silicon devices'**

**EP 0 619 385 B1**

## Description

Le borophosphosilicate est communément utilisé dans l'industrie microélectronique, sous une forme amorphe désignée en vocable anglo-saxon par "borophosphosilicate glass" ou BPSG, comme oxyde d'isolation avant le premier dépôt métallique destiné à former un premier niveau de liaison électrique des circuits intégrés.

Ce matériau présente un double intérêt. Il provoque en premier lieu un effet de getter, soit de protection, du phosphore contre les contaminations par des ions alcalins, et, en deuxième lieu, une diminution de la température nécessaire à l'obtention d'un effet de planarisation par une opération de fluage, du fait de l'introduction de bore.

L'effet de planarisation obtenu après l'opération de fluage est directement lié à la teneur en bore du borophosphosilicate ou BPSG. Le contrôle, la maîtrise et la reproductibilité de cette teneur sont donc des paramètres essentiels de la qualité de fabrication des circuits intégrés finalement obtenus.

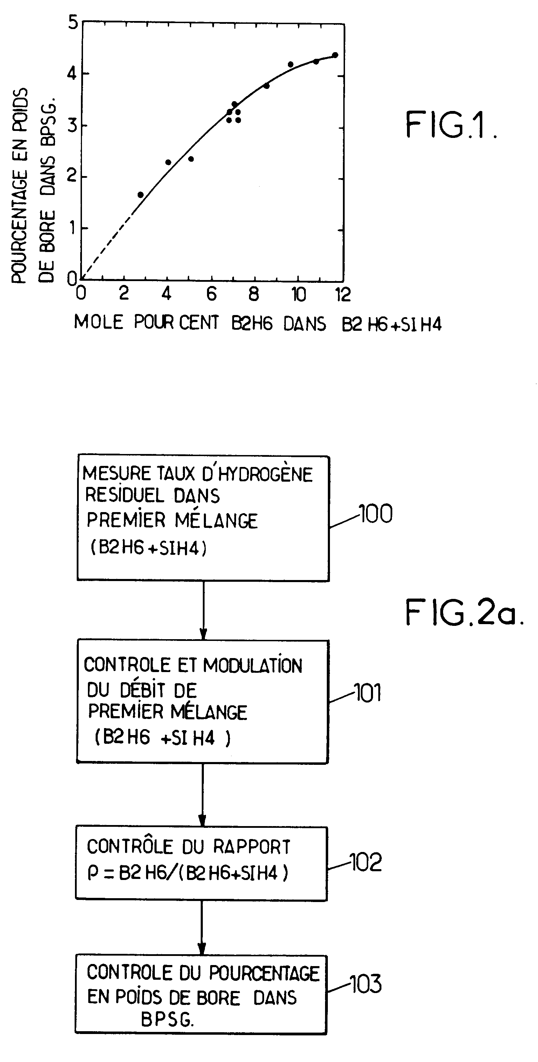

A l'heure actuelle, le BPSG est obtenu à partir de l'oxydation du silane, SiH4, du diborane B2H6 et de la phosphine PH3 dans un réacteur de type à dépôt chimique en phase vapeur LPCVD. Pour des raisons impératives de sécurité, le silane s'enflammant de manière quasi spontanée à l'air libre, le diborane et la phosphine sont conditionnés en bouteilles en mélange à 30% de diborane pour 70% de silane et respectivement 30% de phosphine pour 70% de silane. Le dopage en teneur en bore du BPSG est contrôlé à l'aide du rapport de borane/(diborane + silane) à partir de l'abaque représenté en figure 1.

Les problèmes rencontrés pour contrôler, dans ces conditions, la teneur en bore du BPSG sont d'une double nature.

En première lieu il est nécessaire de modifier, en particulier augmenter, de manière sensiblement monotone, le débit de mélange diborane/silane tout au long de la période d'utilisation de la bouteille contenant ce mélange diborane/silane et de valider chaque modification ou correction par une opération de mesure de la teneur en bore du BPSG. Cette opération, nécessaire, est délicate et fastidieuse et ne permet, en tout état de cause, qu'un réglage approximatif, temporaire par défaut, les conditions correctes de réglage n'étant effectivement obtenues que pour une fraction de chaque plage temporaire de réglage.

En deuxième lieu, lors du changement de la bouteille d'alimentation en diborane, la reproductibilité des réglages successifs est médiocre, ce qui entraîne nécessairement des opérations de réglage impératives coûteuses en temps, et donc imputables au temps de production de chaque réacteur.

La présente invention a pour objet de remédier aux inconvénients précités, afin de permettre la mise en oeuvre d'un processus de fabrication du borophosphosilicate BPSG véritablement industriel.

Un autre objet de la présente invention est également la fourniture d'un processus de fabrication du borophosphosilicate BPSG entièrement automatisé, l'intervention humaine pouvant être réduite au seul changement des bouteilles d'alimentation en mélanges de gaz ou en gaz, grâce à la mise en oeuvre d'un procédé et d'un dispositif de contrôle de la teneur en bore du borophosphosilicate BPSG totalement autonomes.

Le procédé de contrôle de la teneur en bore du borophosphosilicate, BPSG, obtenu par oxydation du silane, du diborane et de la phosphine dans un réacteur, à partir d'un premier mélange gazeux diborane/silane et d'un deuxième mélange gazeux phosphine/silane, par le contrôle du rapport $\rho$ = diborane/(diborane + silane) du mélange résultant du mélange des premier et deuxième mélanges gazeux, objet de la présente invention, est remarquable en ce qu'il consiste à mesurer, dans le premier mélange, le taux d'hydrogène résiduel puis à moduler le débit massique du premier mélange en fonction de la valeur du taux d'hydrogène résiduel, ce qui permet de réguler la teneur en bore du borophosphosilicate ainsi obtenu, par le contrôle du rapport $\rho$ = diborane/(diborane + silane).

Le dispositif de contrôle de la teneur en bore du borophosphosilicate, BPSG, obtenu par oxydation du silane, du diborane et de la phosphine dans un réacteur, alimenté à partir d'une ligne d'alimentation en un premier mélange gazeux diborane/silane, en un deuxième mélange gazeux phosphine/silane et en un flux de silane, conformément au procédé selon l'invention, est remarquable en ce qu'il comprend un circuit de mesure de la masse volumique du premier mélange délivrant un signal de mesure de la masse volumique du premier mélange, des circuits de mesure du débit massique du premier respectivement du deuxième mélange et du flux de silane, ces circuits de mesure étant connectés sur la ligne d'alimentation correspondante du réacteur, chaque circuit de mesure délivrant un signal de mesure de débit massique correspondant, un circuit de commande du débit massique du premier mélange connecté sur la ligne d'alimentation en premier mélange du réacteur. Un calculateur est prévu, lequel reçoit le signal de mesure de la masse volumique du premier mélange et les signaux de débit massique des premier et deuxième mélange et du flux de silane et délivre un signal de commande de correction de débit massique au circuit de commande, ce qui permet de réguler d'une part la valeur du rapport $\rho$ = diborane/(diborane + silane), et, d'autre part, la teneur en bore du borophosphosilicate obtenu dans le réacteur, par l'intermédiaire du contrôle de la teneur en hydrogène résiduel du premier mélange.

Le procédé et le dispositif objet de la présente invention trouvent application à la fabrication des circuits intégrés.

Ils seront mieux compris à la lecture de la description et à l'observation des dessins ci-après dans lesquels, outre la figure 1 relative à l'art antérieur,

- la figure 2a représente un diagramme, sous forme de schéma synoptique, illustratif de la mise en oeuvre du procédé

objet de la présente invention,

- les figures 2b et 2c représentent à titre illustratif un diagramme du résultat de concentration en bore du borophosphosilicate BPSG obtenu, en l'absence de mise en oeuvre du procédé objet de l'invention respectivement lors de la mise en oeuvre du procédé tel qu'illustré en figure 2a,
- la figure 3 représente un schéma illustratif d'un dispositif permettant la mise en oeuvre du procédé objet de l'invention.

Une description plus détaillée du procédé objet de la présente invention sera maintenant donnée en liaison avec les figures 2a et suivantes.

Le borophosphosilicate, BPSG, est obtenu par oxydation du silane $SiH_4$ du diborane $B_2H_6$ et de la phosphine $PH_3$ dans un réacteur du type à dépôt chimique en phase vapeur LPCVD. Les gaz précités sont amenés dans le réacteur sous forme d'un premier mélange gazeux diborane/silane et d'un deuxième mélange gazeux phosphine/silane, un flux de silane pur pouvant être le cas échéant également délivré au réacteur précité.

Le procédé de contrôle de la teneur en bore du borophosphosilicate, selon la présente invention, est effectué par le contrôle du rapport $\rho$ = diborane/(diborane + silane) du mélange résultant du mélange des premier et deuxième mélanges gazeux dans le réacteur.

Selon un aspect particulièrement avantageux du procédé objet de la présente invention, le procédé consiste à mesurer en une étape notée 100 sur la figure 2a, dans le premier mélange, le taux d'hydrogène résiduel puis à moduler dans une étape notée 101, le débit massique du premier mélange en fonction de la valeur du taux d'hydrogène résiduel de celui-ci.

On indique que l'hydrogène résiduel apparaît dans ce premier mélange du fait de la décomposition du diborane en boranes lourds et en hydrogène. De ce fait, la teneur du premier mélange en hydrogène résiduel est bien entendu représentative de la composition en masse de ce mélange, ce qui permet ainsi, par la mesure de la masse volumique de ce premier mélange, de déterminer la composition de celui-ci et donc la contribution en diborane dans ce dernier.

Ainsi, le contrôle et la modulation du débit de premier mélange, à l'étape 101 représentée à la figure 2a, permet-elle en une étape 102 d'effectuer le contrôle du rapport $\rho$ = diborane/(diborane + silane) et finalement le contrôle du pourcentage en poids de bore dans le borophosphosilicate, BPSG, à l'étape 103.

D'une manière générale, on indique que le premier mélange est un mélange à P% de diborane et 100-P% de silane, le deuxième mélange étant un mélange à P% de phosphine et 100-P% de silane.

Dans ces conditions, conformément au procédé objet de la présente invention, le taux d'hydrogène mesuré dans le premier mélange a une valeur $\chi$, cette valeur étant déterminée par correspondance avec la mesure de masse volumique de ce premier mélange et le rapport $\rho$ = diborane/(diborane + silane) vérifie la relation :

$$\rho = [(\frac{P}{100} - \chi) \cdot A] / [(\frac{P}{100} - \chi) \cdot A + C + \frac{(100-P)}{100} (A + B)]$$

Dans cette relation

A désigne le débit du premier mélange,
B désigne le débit du deuxième mélange,
C désigne le débit du silane,
étant entendu que les débits mesurés sont des débits massiques,
$\chi$ désigne le taux d'hydrogène résiduel du premier mélange.

D'une manière habituelle, et pour le conditionnement des différents mélanges précédemment indiqués dans la description, on indique que P = 30.

Des essais expérimentaux ont été effectués en tenant compte du taux d'hydrogène dans la ligne et en supposant le premier mélange et le deuxième mélange conditionnés et livrés dans les conditions précédemment mentionnées.

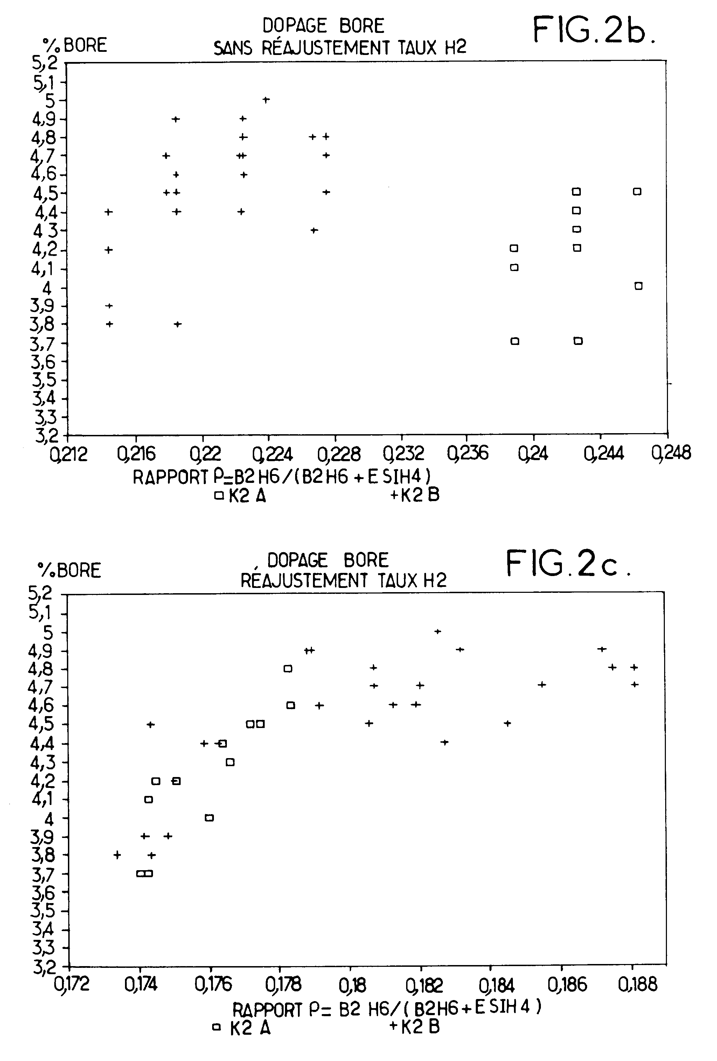

Les résultats obtenus dans un réacteur de type LPCVD, pour deux bouteilles d'alimentation différentes successives durant toute la durée de leur utilisation sont représentés en figure 2b et 2c, les deux bouteilles successives utilisées étant bien entendu des bouteilles quelconques disponibles dans le commerce, les figures 2b et 2c représentant les courbes de pourcentage en bore dans le borophosphosilicate en fonction du rapport $\rho$ = diborane/(diborane + silane), la teneur en bore étant mesurée par colorimétrie (attaque chimique). Sur les courbes précitées, les annotations K2A et K2B correspondent respectivement aux deux bouteilles successives du premier mélange testé et à une variation de 5 à 10 % et de 3 à 7 % de la teneur en hydrogène sur la période d'utilisation, c'est-à-dire sur deux mois environ. La figure 2b ne tient pas compte du taux d'hydrogène résiduel et le rapport $\rho$ diborane/(diborane + silane) est calculé à l'aide de la formule ci-après : diborane/diborane + silane = (0.3*A)/(0.3*A + C + 0.7*(A+B))

Au contraire, la figure 2c prend en compte le taux d'hydrogène résiduel dans la ligne d'alimentation en premier mélange diborane/silane. Le rapport $\rho$ = diborane/(diborane + silane) est calculé à l'aide de la relation donnée précédemment dans la description.

En premier lieu, on constate une bonne cohérence entre les courbes tracées pour les deux bouteilles successives par rapport à celles indiquées dans l'état de la technique, en particulier dans la publication intitulée "Optimized chemical vapor deposition of borophosphosilicate glass films" de W. Kern, W.A. Kurylo and C.J. Tino, R.C.D. Review 46,(2), Juin 1985 page 117.

On constate également l'existence d'un comportement identique d'une bouteille à l'autre. Dans le cas de la figure 2b, c'est-à-dire en l'absence de réajustement de débit du premier mélange en fonction de la teneur en hydrogène résiduel de celui-ci, le nuage de points observé ne permet pas de maîtriser la teneur en bore du borophosphosilicate BPSG.

Dans le cas de la figure 2c au contraire, le réajustement du débit en fonction du taux d'hydrogène résiduel dans le premier mélange permet d'évaluer et de réajuster le rapport $\rho$ = diborane/(diborane + silane) et ainsi de contrôler la teneur en bore du borophosphosilicate obtenu dans le réacteur.

On indique que la mesure du taux d'hydrogène résiduel dans le premier mélange et l'application de la relation permettant de déterminer le rapport $\rho$ = diborane/(diborane + silane) permet de contrôler la teneur en bore et d'assurer la reproductibilité sur la durée de vie d'une bouteille du mélange diborane/silane ou premier mélange, ainsi que d'une bouteille à l'autre.

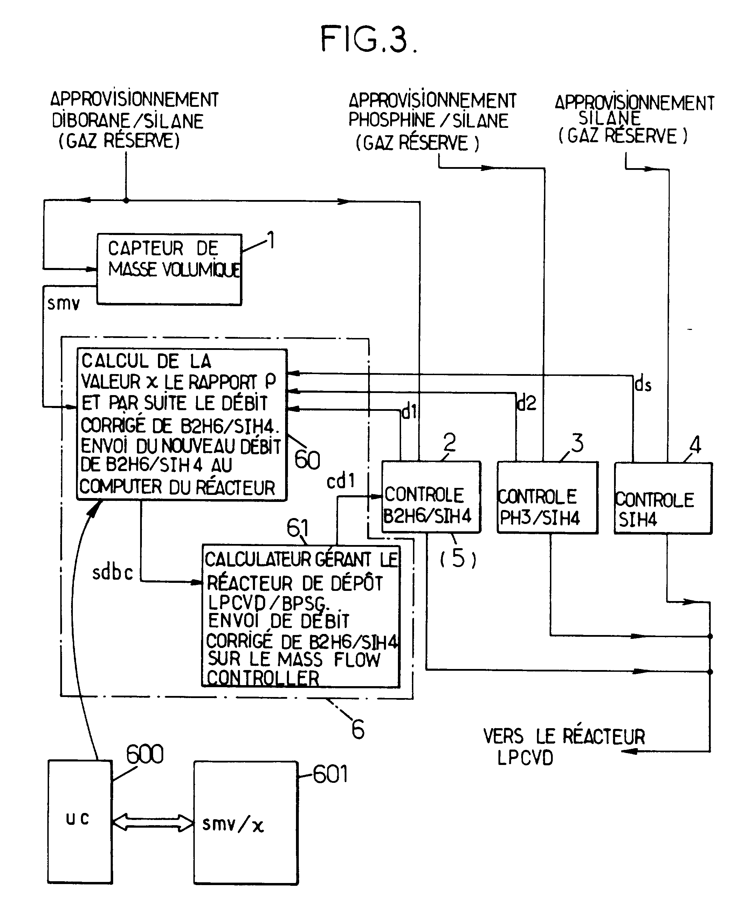

Une description plus détaillée d'un dispositif permettant la mise en oeuvre du procédé, objet de la présente invention précédemment décrit, sera maintenant donnée en liaison avec la figure 3.

Selon la figure précitée, le dispositif de contrôle de la teneur en bore du borophosphosilicate BPSG obtenu par oxydation du silane, du diborane et de la phosphine, dans un réacteur, ce réacteur non représenté sur la figure 3 étant alimenté à partir d'une ligne d'alimentation en un premier mélange gazeux diborane/silane, en un deuxième mélange gazeux phosphine/silane et en un flux de silane et ce contrôle étant effectué par le contrôle du rapport $\rho$ = diborane/(diborane + silane) du mélange résultant, conformément au procédé précédemment décrit dans la description, comprend de manière illustrative non limitative un circuit ou capteur 1 de masse volumique du premier mélange, connecté par exemple en parallèle sur la ligne d'alimentation en premier mélange du réacteur, ce circuit capteur 1 délivrant un signal de mesure de la masse volumique du premier mélange précité. Ce signal est noté smv.

Le dispositif selon l'invention comporte également des circuits de mesure notés 2, 3, 4 du débit massique du premier respectivement du deuxième mélange, ainsi que du flux de silane, ces circuits de mesure étant connectés sur la ligne d'alimentation correspondante du réacteur. Chaque circuit délivre un signal de mesure de débit massique correspondant lesquels, par commodité sont notés d1, d2, ds.

En outre, le dispositif représenté en figure 3 comprend un circuit noté (5) de commande du débit massique du premier mélange connecté sur la ligne d'alimentation en premier mélange du réacteur. Enfin, un calculateur 6 reçoit le signal de mesure de la masse volumique smv du premier mélange ainsi que les signaux de débit massique d1, d2, ds du premier et du deuxième mélange respectivement du flux de silane, ce calculateur délivrant un signal de commande de correction de débit massique, noté cdl, au circuit de commande (5), ce qui permet de réguler, d'une part, la valeur du rapport $\rho$ = diborane/(diborane + silane) et, d'autre part, la teneur en bore du borophosphosilicate obtenu dans le réacteur par l'intermédiaire du contrôle de la teneur en hydrogène résiduel du premier mélange.

Dans un mode de réalisation préférentiel, on indique que le circuit de mesure 2 et le circuit de commande du débit massique (5) du premier mélange sont constitués par un même débit-mètre massique. Dans un mode de réalisation particulier non limitatif, les circuits 2, 3, 4 et 5 sont constitués par un débit-mètre massique commercialisé par la société TYLAN sous la référence FC 280.

Dans le même mode de réalisation, on indique que le circuit 1 de mesure de la masse volumique du premier mélange était constitué par un appareil commercialisé par la société SARASOTA sous la référence CBYT FD 771.

Dans un mode de réalisation préférentiel tel que représenté en figure 3, le calculateur 6 peut comprendre avantageusement un calculateur auxiliaire 60 recevant les signaux de mesure de la masse volumique du premier mélange ainsi que les signaux de débit massique d1, d2, ds et permettant de déterminer, à partir des signaux précités, la valeur $\chi$ du taux d'hydrogène résiduel du premier mélange ainsi que la valeur $\rho$ du rapport diborane/(diborane + silane) vérifiant la relation précédemment mentionnée dans la description.

Le calculateur 6 comporte alors avantageusement un calculateur-maître noté 61 lequel reçoit le signal de débit corrigé noté sdbc, du premier mélange, et délivre le signal de commande de correction de débit massique noté cd1 au circuit de commande (5).

De préférence, on indique que le calculateur auxiliaire 60 peut être constitué par un calculateur dédié pouvant comporter une table de consultation 601 reliée à une unité centrale 600 laquelle permet, par lecture directe de la table de consultation, de déterminer la teneur en hydrogène résiduel du premier mélange à partir de la masse volumique de ce dernier.

Bien entendu, le calculateur auxiliaire 60 peut être remplacé par un micro-ordinateur portable par exemple dans lequel les programmes ou données correspondantes sont également chargés.

En ce qui concerne la réalisation du dispositif représenté en figure 3, on indique que les différents capteurs de masse volumique ou de mesure de débit massique du premier mélange, respectivement du premier et du deuxième mélanges et du flux de silane, sont des circuits échantillonneurs et que la période d'échantillonnage de la masse volumique du premier mélange est comprise par exemple entre 10 et 15 minutes, alors que la période d'échantillonnage des débits massiques est comprise par exemple entre 1 à 3 minutes.

On a ainsi décrit un procédé et un dispositif de contrôle de la teneur en bore du borophosphosilicate utilisé dans la mise en oeuvre des circuits intégrés particulièrement performants dans la mesure où il suffit pour une teneur en bore désirée de maintenir le rapport diborane/(diborane + silane) constant, en couplant la modification du débit massique diborane/silane à la variation du taux d'hydrogène résiduel mesuré dans la ligne d'alimentation du premier mélange diborane/silane. La mesure de la teneur en bore par colorimétrie au cours du processus de fabrication des circuits intégrés correspondants n'est alors plus nécessaire.

**Revendications**

1. Procédé de contrôle de la teneur en bore du borophosphosilicate, obtenu par oxydation du silane, du diborane et de la phosphine dans un réacteur, à partir d'un premier mélange gazeux diborane/silane et d'un deuxième mélange gazeux phosphine/silane, par le contrôle du rapport $\rho$ = diborane/(diborane + silane) du mélange résultant du mélange des premier et deuxième mélanges gazeux, caractérisé en ce que ledit procédé consiste :

   - à mesurer, dans ledit premier mélange, le taux d'hydrogène résiduel,
   - à moduler le débit massique dudit premier mélange en fonction de la valeur du taux d'hydrogène résiduel, ce qui permet de réguler la teneur en bore du borophosphosilicate ainsi obtenu, par le contrôle de la valeur dudit rapport $\rho$ = diborane/(diborane + silane).

2. Procédé selon la revendication 1, caractérisé en ce que ledit premier mélange étant un mélange à P% de diborane et (100-P)% de silane et ledit deuxième mélange étant un mélange à P% de phosphine et (100-P)% de silane, le taux d'hydrogène mesuré dans ledit premier mélange ayant une valeur $\chi$, le rapport $\rho$ = diborane/(diborane + silane) vérifie la relation :

$$\rho = [(\frac{P}{100} - \chi) \, . \, A] / [(\frac{P}{100} - \chi) \, . \, A + C + \frac{(100-P)}{100} \, (A + B) \, ]$$

   relation dans laquelle

   A désigne le débit du premier mélange
   B désigne le débit du deuxième mélange
   C désigne le débit du silane
   $\chi$ désigne le taux d'hydrogène résiduel du premier mélange.

3. Procédé selon la revendication 1 ou 2, caractérisé en ce que l'étape consistant à mesurer dans ledit premier mélange, le taux d'hydrogène résiduel consiste :

   - à mesurer la masse volumique dudit premier mélange,
   - à déterminer le taux d'hydrogène résiduel d'hydrogène du premier mélange à partir de la masse volumique de celui-ci, suite à la décomposition du diborane en boranes lourds et en hydrogène.

4. Dispositif de contrôle de la teneur en bore du borophosphosilicate obtenu par oxydation du silane, du diborane et de la phosphine dans un réacteur, ce réacteur étant alimenté à partir d'une ligne d'alimentation en un premier mélange gazeux diborane/silane et en un deuxième mélange gazeux phosphine/silane et un flux de silane, ce contrôle étant effectué par le contrôle du rapport $\rho$ = diborane/(diborane + silane) du mélange résultant, caractérisé en ce que ledit dispositif comprend :

   - des moyens de mesure de la masse volumique dudit premier mélange délivrant un signal de mesure de la masse volumique du premier mélange,
   - des moyens de mesure du débit massique du premier respectivement du deuxième mélange et du flux de silane, lesdits moyens de mesure étant connectés sur la ligne d'alimentation correspondante du réacteur, chaque moyen de mesure étant connectés sur la ligne d'alimentation correspondante du réacteur et délivrant une signal de mesure de débit massique correspondant,
   - des moyens de commande du débit massique dudit premier mélange connectés sur la ligne d'alimentation en premier mélange du réacteur,
   - des moyens de calcul recevant le signal de mesure de la masse volumique du premier mélange et les signaux de débit massique du premier respectivement du deuxième mélange et du flux de silane et délivrant un signal de commande de correction de débit massique auxdits moyens de commande, ce qui permet de réguler d'une part la valeur du rapport ρ = diborane/(diborane + silane), et, d'autre part, la teneur en bore du borophosphosilicate obtenu dans le réacteur par l'intermédiaire du contrôle de la teneur en hydrogène résiduel dudit premier mélange.

5. Dispositif selon la revendication 4, caractérisé en ce que les moyens de mesure et le moyens de commande du débit massique dudit premier mélange sont constitués par un même débit-mètre massique.

6. Dispositif selon l'une des revendications 4 u 5, caractérisé en ce que lesdits moyens de calcul comprennent

- un calculateur auxiliaire recevant les signaux de mesure de la masse volumique du premier mélange et lesdits signaux de débit massique, ce calculateur auxiliaire permettant de déterminer à partir desdits signaux

  . la valeur χ du taux d'hydrogène résiduel du premier mélange,
  . la valeur ρ = diborane/(diborane + silane) vérifiant la relation :

$$\rho = [(\frac{P}{100} - \chi) . A] / [(\frac{P}{100} - \chi) . A + C + \frac{(100\text{-}P)}{100} (A + B)]$$

  relation dans laquelle

  A désigne le débit du premier mélange
  B désigne le débit du deuxième mélange
  C désigne le débit du silane
  X désigne le taux d'hydrogène résiduel du premier mélange et délivrant un signal de débit corrigé dudit premier mélange,

- un calculateur maître recevant ledit signal de débit corrigé dudit premier mélange délivrant ledit signal de commande de correction de débit massique auxdits moyens de commande.

7. Dispositif selon la revendication 6, caractérisé en ce que ledit calculateur auxiliaire est un calculateur dédié, comportant une table de consultation permettant de déterminer par lecture directe la teneur en hydrogène résiduel dudit premier mélange à partir de la masse volumique de ce dernier.

8. Dispositif selon l'une des revendications 4 à 7 précédentes, caractérisé en ce que lesdits moyens de mesure de la masse volumique du premier mélange respectivement du débit massique du premier et du deuxième mélange et du flux de silane sont des moyens échantillonneurs.

9. Dispositif selon la revendication 8, caractérisé en ce que la période d'échantillonnage de la masse volumique du premier mélange est comprise entre 10 et 15 minutes, et la période d'échantillonnage des débits massiques est de 1 à 3 minutes.

**Patentansprüche**

1. Verfahren zur Kontrolle des Borgehaltes des Borphosphorsilikats, das durch Oxidation von Silan, Diboran und Phosphin in einem Reaktor aus einem ersten Gasgemisch von Diboran/Silan und einem zweiten Gasgemisch von Phosphin/Silan durch die Kontrolle des Verhältnisses ρ = Diboran/(Diboran + Silan) des sich aus dem Gemisch des ersten und zweiten Gasgemisches ergebenden Gemisches erhalten wird, dadurch gekennzeichnet, daß das Verfahren beruht auf:

- einem Messen der Restwasserstoffmenge im ersten Gemisch,

- einem Modulieren des Massendurchflusses des ersten Gemisches in Abhangigkeit vom Wert der Restwasserstoffmenge, wodurch der Borgehalt des so erhaltenen Borphosphorsilikats durch die Kontrolle des Wertes des Verhältnisses ρ = Diboran/(Diboran + Silan) geregelt werden kann.

2. Verfahren nach Anspruch 1, dadurch gekennzeichnet, daß das erste Gemisch ein Gemisch aus P% Diboran und (100-P)% Silan ist und das zweite Gemisch ein Gemisch aus P% Phosphin und (100-P)% Silan ist und die in dem ersten Gemisch gemessene Wasserstoffmenge einen Wert $\chi$ hat, wobei das Verhältnis $\rho$ = Diboran/(Diboran + Silan) die Beziehung erfüllt:

$$\rho = [(\frac{P}{100} - \chi) \cdot A] / [(\frac{P}{100} - \chi) \cdot A + C + \frac{(100-P)}{100} \ (A + B)]$$

eine Beziehung, in welcher A den Durchfluß des ersten Gemisches bezeichnet, B den Durchfluß des zweiten Gemisches bezeichnet, C den Durchfluß des Silan bezeichnet, $\chi$ die Restwasserstoffmenge des ersten Gemisches bezeichnet.

3. Verfahren nach Anspruch 1 oder 2, dadurch gekennzeichnet, daß der aus einem Messen der Restwasserstoffmenge im ersten Gemisch bestehende Schritt darauf beruht:

- die volumenbezogene Masse des ersten Gemisches zu messen,

- die Restwasserstoffmenge des Wasserstoffs des ersten Gemisches ausgehend von seiner volumenbezogenen Masse, nach der Zersetzung des Diborans in schweres Bor und wasserstoff, zu messen.

4. Vorrichtung zur Kontrolle des Borgehalts des durch Oxidation von Silan, Diboran und Phosphin in einem Reaktor erhaltenen Borphosphorsilikats, wobei der Reaktor aus einer Versorgungsleitung für ein erstes Gasgemisch von Diboran/Silan und für ein zweites Gasgemisch von Phosphin/Silan und für einen Silanstrom versorgt wird, wobei die Kontrolle durch die Kontrolle des Verhältnisses $\rho$ = Diboran/(Diboran + Silan) des resultierenden Gemisches durchgeführt wird, dadurch gekennzeichnet, daß die Vorrichtung umfaßt:

- Mittel zum Messen der volumenbezogenen Masse des ersten Gemisches, die ein Meßsignal von der volumenbezogenen Masse des ersten Gemisches liefern,

- Mittel zum Messen des Massendurchflusses des ersten bzw des zweiten Gemisches und des Silanstromes, wobei die Meßmittel auf der entsprechenden Versorgungsleitung des Reaktors angebracht sind, wobei jedes Meßmittel auf der entsprechenden Versorgungsleitung des Reaktors angebracht ist und ein Meßsignal des entsprechenden Massendurchflusses liefert,

- Mittel zum Steuern des Massendurchflusses des ersten Gemisches, die auf der für das erste Gemisch bestimmten Versorgungsleitung des Reaktors angebracht sind,

- Berechnungsmittel, die das Meßsignal von der volumenbezogenen Masse des ersten Gemisches und die Signale des Massendurchflusses des ersten bzw. des zweiten Gemisches und des Silanstromes erhalten und ein Steuersignal zur Korrektur des Massendurchflusses an die Steuermittel liefern, wodurch einerseits der Wert des Verhältnisses $\rho$ = Diboran/(Diboran + Silan) und andererseits der Borgehalt des in dem Reaktor erhaltenen Borphosphorsilikats mit Hilfe der Kontrolle der Restwasserstoffmenge des ersten Gemisches geregelt werden kann.

5. Vorrichtung nach Anspruch 4, dadurch gekennzeichnet, daß die Mittel zum Messen und die Mittel zum Steuern des Massendurchflusses des ersten Gemisches durch einen gleichen Massendurchfluß-Meßzähler gebildet werden.

6. Vorrichtung nach einem der Ansprüche 4 oder 5, dadurch gekennzeichnet, daß die Berechnungsmittel umfassen

- einen Hilfsrechner, der die Meßsignale von der volumenbezogenen Masse des ersten Gemisches und die Signale des Massendurchflusses erhält, wobei der Hilfsrechner aus diesen Signalen bestimmen kann

- den Wert $\chi$ der Restwasserstoffmenge des ersten Gemisches,

- den Wert $\rho$ = Diboran/(Diboran + Silan), der die Beziehung erfüllt:

$$\rho = [(\frac{P}{100} - \chi) \cdot A] / [(\frac{P}{100} - \chi) \cdot A + C + \frac{(100-P)}{100} \ (A + B)]$$

eine Beziehung, in der A den Durchfluß des ersten Gemisches bezeichnet, B den Durchfluß des zweiten Gemisches bezeichnet, C den Durchfluß des Silan bezeichnet, $\chi$ die Restwasserstoffmenge des ersten Gemisches bezeichnet,
und ein korrigiertes Durchflußsignal des ersten Gemisches liefert

- einen Hauptrechner, der bei Erhalt des korrigierten Durchflußsignals des ersten Gemisches das Steuersignal zur Korrektur des Massendurchflusses an die Steuermittel liefert.

**7.** Vorrichtung nach Anspruch 6, dadurch gekennzeichnet, daß der Hilfsrechner ein angepaßter Rechner ist, der eine Arbeitstabelle aufweist, mit der durch direktes Ablesen die Restwasserstoffmenge des ersten Gemisches aus der volumenbezogenen Masse des letzteren bestimmbar ist.

**8.** Vorrichtung nach einem der vorstehenden Ansprüche 4-7, dadurch gekennzeichnet, daß die Mittel zum Messen der volumenbezogenen Masse des ersten Gemisches bzw. des Massendurchflusses des ersten und des zweiten Gemisches und des Silanstromes Abtastmittel sind.

**9.** Vorrichtung nach Anspruch 8, dadurch gekennzeichnet, daß die Abtastdauer der volumenbezogenen Masse des ersten Gemisches zwischen 10 und 15 Minuten liegt und die Abtastdauer der Massendurchflüsse 1 bis 3 Minuten beträgt.

## Claims

**1.** Method for monitoring the boron content of the borophosphosilicate obtained by oxidation of silane, of diborane and of phosphine in a reactor, starting with a first, diborane/silane gas mixture and a second, phosphine/silane gas mixture, by monitoring the ratio $\rho$ = diborane/(diborane + silane) of the mixture resulting from the mixing of the first and second gas mixtures, characterized in that the said method consists :

- in measuring, in the said first mixture, the content of residual hydrogen,
- in modulating the mass flow rate of the said first mixture as a function of the value of the content of residual hydrogen, thereby making it possible to regulate the boron content of the borophosphosilicate thus obtained, by monitoring the value of the said ratio $\rho$ = diborane/(diborane + silane).

**2.** Method according to Claim 1, characterized in that, since the said first mixture is a mixture having P % of diborane and (100-P) % of silane and since the said second mixture is a mixture having P % of phosphine and (100-P) % of silane, the content of hydrogen measured in the said first mixture having a value $\chi$, the ratio $\rho$ = diborane/(diborane + silane) satisfies the equation :

$$\rho = [(\frac{P}{100} - \chi) . A] / [(\frac{P}{100} - \chi) . A + C + \frac{(100-P)}{100} (A + B)]$$

in which equation

  A designates the flow rate of the first mixture
  B designates the flow rate of the second mixture
  C designates the flow rate of the silane
  $\chi$ designates the content of residual hydrogen in the first mixture.

**3.** Method according to Claim 1 or 2, characterized in that the step consisting in measuring the content of residual hydrogen in the said first mixture consists :

- in measuring the density of the said first mixture,
- in determining the content of residual hydrogen in the first mixture from the density of the latter, following the decomposition of the diborane into heavy boranes and into hydrogen.

**4.** Device for monitoring the boron content of the borophosphosilicate obtained by oxidation of silane, of diborane and of phosphine in a reactor, this reactor being supplied from a line for supplying a first, diborane/silane gas mixture and a second, phosphine/silane gas mixture and a flow of silane, this monitoring being carried out by monitoring the ratio $\rho$ = diborane/(diborane + silane) of the resulting mixture, characterized in that the said device comprises :

- means for measuring the density of the said first mixture, delivering a density measurement signal for the first mixture,
- means for measuring the density of the first and respectively second mixture and of the flow of silane, the said measurement means being connected up to the corresponding supply line of the reactor, each measurement means being connected up to the corresponding supply line of the reactor and delivering a corresponding mass flow-rate measurement signal,

- means for controlling the mass flow rate of the said first mixture, these being connected up to the first-mixture supply line of the reactor,
- computing means receiving the density measurement signal for the first mixture and the mass flow-rate signals for the first and respectively second mixture and for the flow of silane and delivering a mass flow-rate correction control signal to the said control means, thereby making it possible to regulate, on the one hand, the value of the ratio $\rho$ = diborane/(diborane + silane) and, on the other hand, the boron content of the borophosphosilicate obtained in the reactor by means of the monitoring of the residual hydrogen content of the said first mixture.

5. Device according to Claim 4, characterized in that the means for measuring and the means for controlling the mass flow rate of the said first mixture are constituted by the same mass flow meter.

6. Device according to one of Claims 4 or 5, characterized in that the said computing means comprise :

- an auxiliary computer receiving the density measurement signals for the first mixture and the said mass flow-rate signals, this auxiliary computer making it possible to determine, from the said signals,

  . the value $\chi$ of the content of residual hydrogen in the first mixture,
  . the value $\rho$ = diborane/(diborane + silane) satisfying the equation :

$$\rho = [(\frac{P}{100} - \chi) \cdot A] / [(\frac{P}{100} - \chi) \cdot A + C + \frac{(100-P)}{100}(A + B)]$$

in which equation

A designates the flow rate of the first mixture
B designates the flow rate of the second mixture
C designates the flow rate of the silane
$\chi$ designates the content of residual hydrogen in the first mixture, and delivering a corrected flow-rate signal for the said first mixture,

- a master computer receiving the said corrected flow-rate signal for the said first mixture delivering the said mass flow-rate correction control signal to the said control means.

7. Device according to Claim 6, characterized in that the said auxiliary computer is a dedicated computer, which includes a consultation table making it possible to determine by direct reading the residual-hydrogen content of the said first mixture from the density of the latter.

8. Device according to one of the previous Claims 4 to 7, characterized in that the said means for measuring the density of the first mixture and respectively of the mass flow-rate of the first and second mixture and of the flow of silane are sampling means.

9. Device according to Claim 8, characterized in that the density sampling period for the first mixture is between 10 and 15 minutes and the mass flow-rate sampling period is from 1 to 3 minutes.

FIG.1.

POURCENTAGE EN POIDS DE BORE DANS BPSG.

MOLE POUR CENT B2H6 DANS B2H6+SIH4

| MESURE TAUX D'HYDROGÈNE RESIDUEL DANS PREMIER MÉLANGE ($B_2H_6 + SIH_4$) | 100 |

FIG.2a.

| CONTROLE ET MODULATION DU DÉBIT DE PREMIER MÉLANGE ($B_2H_6 + SIH_4$) | 101 |

| CONTRÔLE DU RAPPORT $\rho = B_2H_6 / (B_2H_6 + SIH_4)$ | 102 |

| CONTROLE DU POURCENTAGE EN POIDS DE BORE DANS BPSG. | 103 |

DOPAGE BORE
SANS RÉAJUSTEMENT TAUX H2

FIG.2b.

RAPPORT P = B2 H6 / ( B2 H6 + E SIH4 )
□ K2 A          + K2 B

DOPAGE BORE
RÉAJUSTEMENT TAUX H2

FIG.2c.

RAPPORT P = B2 H6 / ( B2H6 + E SIH4 )
□ K2 A          + K2 B

# FIG.3.

APPROVISIONNEMENT
DIBORANE /SILANE
( GAZ RÉSERVE )

APPROVISIONNEMENT
PHOSPHINE / SILANE
( GAZ RÉSERVE )

APPROVISIONNEMENT
SILANE
( GAZ RÉSERVE )

CAPTEUR DE
MASSE VOLUMIQUE    1

smv

CALCUL DE LA
VALEUR x LE RAPPORT ρ
ET PAR SUITE LE DÉBIT
CORRIGÉ DE B2H6/SIH4.
ENVOI DU NOUVEAU DÉBIT
DE B2H6/SIH4 AU
COMPUTER DU RÉACTEUR    60

ds

d1

d2

cd1

2                3                4

CONTROLE
B2H6/SIH4

CONTROLE
PH3/SIH4

CONTROLE
SIH4

( 5 )

61

sdbc

CALCULATEUR GÉRANT LE
RÉACTEUR DE DÉPÔT
LPCVD /BPSG.
ENVOI DE DÉBIT
CORRIGÉ DE B2H6/SIH4
SUR LE MASS FLOW
CONTROLLER

6

VERS LE RÉACTEUR
LPCVD

600              601

U C          smv/x